# NEUE EUROPÄISCHE PATENTSCHRIFT

(11) **EP 1 902 155 B2**
(45) Veröffentlichungstag und Bekanntmachung des Hinweises auf die Entscheidung über den Einspruch: **02.04.2025**
(45) Hinweis auf die Patenterteilung: 03.02.2016
(21) Anmeldenummer: 06777574.2
(22) Anmeldetag: 04.07.2006
(51) Int. Cl.: C23C 28/04, C23C 16/34, C23C 30/00

(54) **HARTSTOFFBESCHICHTETE KÖRPER UND VERFAHREN ZU DEREN HERSTELLUNG**
HARD-COATED BODY AND METHOD FOR PRODUCTION THEREOF
CORPS RECOUVERTS D'UNE SUBSTANCE DURE, ET LEUR PROCEDE DE PRODUCTION

(30) Priorität: 04.07.2005 DE 102005032860
(43) Veröffentlichungstag der Anmeldung: 26.03.2008
(73) Patentinhaber: Fraunhofer-Gesellschaft zur Förderung der angewandten Forschung e.V., 80686 München (DE)
(72) Erfinder: ENDLER, Ingolf, 01640 Coswig (DE)
(74) Vertreter: Maiwald GmbH
(86) Internationale Anmeldenummer: PCT/EP2006/063881
(87) Internationale Veröffentlichungsnummer: WO 2007/003648

(56) Entgegenhaltungen:
- WO-A2-03/085152
- JP-A- 2001 341 008
- US-B1- 6 238 739
- R PRANGE ET AL: "Plasma-enhanced CVD of (Ti,Al)N films from chloridic precursors in a DC glow discharge", SURFACE AND COATINGS TECHNOLOGY, vol. 133-134, 1 November 2000 (2000-11-01), pages 208 - 214, XP055179843, ISSN: 0257-8972, DOI: 10.1016/S0257-8972(00)00941-5
- PRANGE ET AL.: "Plasma-enhanced CVD of (Ti,Al)N films from chloridic precursors in a DC glow discharge", SURF. COAT. TECHNOL., vol. 133-134, 2000, pages 208 - 214
- LIU ET AL.: "Using Simultaneous Deposition and Rapid Growth to Produce Nanostructured Composite Films of AIN/TiN by Chemical Vapor Deposition", J. AM. CERAM. SOC., vol. 79, no. 5, 1996, pages 1335 - 1342
- LEE S-H ET AL: "(TI1-XALX)N COATINGS BY PLASMA-ENHANCED CHEMICAL VAPOR DEPOSITION", JOURNAL OF VACUUM SCIENCE AND TECHNOLOGY: PART A, AVS /AIP, MELVILLE, NY, US, vol. 12, no. 4, 1 July 1994 (1994-07-01), pages 1602 - 1607, XP000608885, ISSN: 0734-2101
- WAHLSTROM U ET AL: "CRYSTAL GROWTH AND MICROSTRUCTURE OF POLYCRYSTALLINE TI1-XALXN ALLOY FILMS DEPOSITION BY ULTRA-HIGH-VACUUM DUAL-TARGET MAGNETRON SPUTTERING", THIN SOLID FILMS, ELSEVIER-SEQUOIA S.A. LAUSANNE, CH, vol. 235, no. 1/2, 25 November 1993 (1993-11-25), pages 62 - 70, XP000408749, ISSN: 0040-6090
- HÖRLING A ET AL: "Thermal stability of arc evaporated high aluminum-content Ti1-xAlxN thin films", JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 5, September 2002 (2002-09-01), pages 1815 - 1823, XP012006202, ISSN: 0734-2101

## Beschreibung

### Technisches Gebiet

Die Erfindung betrifft hartstoffbeschichtete Körper mit einem ein- oder mehrlagigen Schichtsystem, das mindestens eine Ti₁₋ₓAlₓN-Hartstoffschicht enthält, und ein Verfahren zu deren Herstellung. Die erfindungsgemäße Beschichtung kann insbesondere bei Werkzeugen aus Stahl, Hartmetallen, Cermets und Keramiken eingesetzt werden, wie Bohrern, Fräsern und Wendeschneidplatten. Die erfindungsgemäß beschichteten Körper weisen eine verbesserte Verschleißfestigkeit und Oxidationsbeständigkeit auf.

### Stand der Technik

Die Herstellung von Verschleißschutzschichten in bestimmten Bereichen des Materialsystems Ti-Al-N ist entsprechend der WO 03/085152 A2 bereits bekannt. Dabei ist es möglich, monophasige TiAlN-Schichten mit der NaCl-Struktur bei AlN-Gehalten bis 67% herzustellen. Diese Schichten, die mittels PVD erzeugt werden, weisen Gitterkonstanten a_{fcc} zwischen 0,412 nm und 0,424 nm auf (R. Cremer, M. Witthaut, A. von Richthofen, D. Neuschütz, Fresenius J. Anal. Chem. 361 (1998) 642-645). Solche kubischen TiAlN-Schichten besitzen eine relativ hohe Härte und Verschleißfestigkeit. Bei AlN-Gehalten > 67% entsteht allerdings ein Gemisch aus kubischem und hexagonalem TiAlN und bei einem AlN-Anteil > 75% nur noch die weichere und nicht verschleißfeste hexagonale Wurtzitstruktur.

Es ist auch bekannt, dass die Oxidationsbeständigkeit von kubischen TiAlN-Schichten mit steigendem AlN-Gehalt zunimmt (M. Kawate, A. Kimura, T. Suzuki, Surface and Coatings Technology 165 (2003) 163-167). Aus der wissenschaftlichen Literatur zur TiAlN-Herstellung mittels PVD ergibt sich jedoch die Ansicht, dass oberhalb von 750°C praktisch keine einphasigen kubischen TiAlN-Schichten mit hohem AlN-Anteil mehr entstehen können, beziehungsweise dass bei Ti₁₋ₓAlₓN-Phasen mit x > 0,75 immer die hexagonale Wurtzitstruktur vorliegt (K. Kutschej, P.H. Mayrhofer, M. Kathrein, C. Michotte, P. Polcik, C. Mitterer, Proc. 16th Int. Plansee Seminar, May 30 - June 03, 2005, Reutte, Austria, Vol. 2, p. 774 - 788).

Es wurde auch bereits gefunden, dass mittels Plasma-CVD einphasige Ti₁₋ₓAlₓN-Hartstoffschichten mit x bis 0,9 herstellbar sind (R. Prange, Diss. RTHW Aachen, 1999, Fortschritt-Berichte VDI, 2000, Reihe 5, Nr. 576 sowie O. Kyrylov et al., Surface and Coating Techn. 151-152 (2002) 359-364). Nachteilig hierbei sind jedoch die unzureichende Homogenität der Schichtzusammensetzung und der relativ hohe Chlorgehalt in der Schicht. Außerdem ist die Verfahrensdurchführung kompliziert und aufwändig.

Gemäß JP 2001 341008 A ist ein Titan-Aluminium-Nitrat-beschichtetes Werkzeug bekannt, bestehend aus einem Werkzeugkörper und einer einfachen oder mehrlagigen Beschichtungsschicht aus Titan-Aluminium-Nitrat die mindestens Titan, Aluminium und Stickstoff enthält, wobei die Kristallstruktur der Titan-Aluminium-Nitrat-Schicht eine kubische Struktur ist, die Titan-Aluminium-Nitrat-Schicht eine Zugeigenspannung aufweist und der Chloridgehalt der Titan-Aluminium-Nitrat-Schicht 0,01 bis 2 Masse-% beträgt. Der Einbau von Aluminium in das kubische TiAIN-Kristallgitter ist jedoch begrenzt. Die aus dem (111)-Reflex ermittelte Gitterkonstante für diese TiAIN-Schicht wird mit 0,41358 nm angegeben.

Für die Herstellung der bekannten Ti₁₋ₓAlₓN-Hartstoffschichten werden nach dem Stand der Technik PVD- oder Plasma-CVD-Verfahren eingesetzt, die bei Temperaturen unter 700°C betrieben werden (A. Hörling, L. Hultman, M. Oden, J. Sjölen, L. Karlsson, J. Vac. Sci. Technol. A 20 (2002)5, 1815 - 1823 sowie D. Heim, R. Hochreiter, Surface and Coatings Technology 98 (1998) 1553 - 1556). Nachteilig bei diesen Verfahren ist, dass die Beschichtung komplizierter Bauteilgeometrien Schwierigkeiten bereitet. PVD ist ein sehr gerichteter Prozess und Plasma-CVD erfordert eine hohe Plasmahomogenität, da die Plasmaleistungsdichte direkten Einfluss auf das Ti/Al-Atomverhältnis der Schicht hat. Mit den industriell fast ausschließlich eingesetzten PVD-Verfahren ist es nicht möglich, einphasige kubische Ti₁₋ₓAlₓN-Schichten mit x > 0,75 herzustellen.

Da es sich bei kubischen TiAlN-Schichten um eine metastabile Struktur handelt, ist eine Herstellung mit konventionellen CVD-Verfahren bei hohen Temperaturen ≥ 1000°C prinzipiell nicht möglich, weil bei Temperaturen oberhalb 1000°C ein Gemisch aus TiN und hexagonalem AIN entsteht.

Entsprechend der US 6,238,739 B1 ist es auch bekannt, dass durch einen thermischen CVD-Prozess ohne Plasmaunterstützung Ti₁₋ₓAlₓN-Schichten mit x zwischen 0,1 und 0,6 im Temperaturbereich zwischen 550°C und 650°C erhältlich sind, wenn eine Gasmischung von Aluminium- und Titanchloriden sowie NH₃ und H₂ verwendet wird. Der Nachteil dieses speziellen thermischen CVD-Verfahrens besteht ebenfalls in der Eingrenzung auf eine Schichtstöchiometrie x ≤ 0,6 und der Beschränkung auf Temperaturen unter 650°C. Die geringe Beschichtungstemperatur führt zu hohen Chlorgehalten in der Schicht bis 12 At.%, die für die Anwendung schädlich sind (S. Anderbouhr, V. Ghetta, E. Blanquet, C. Chabrol, F. Schuster, C. Bernard, R. Madar, Surface and Coatings Technology 115 (1999) 103 -110).

### Offenbarung der Erfindung

Der Erfindung liegt die Aufgabe zugrunde, bei hartstoffbeschichteten Körpern mit einem ein- oder mehrlagigen Schichtsystem, das mindestens eine Ti₁₋ₓAlₓN-Hartstoffschicht enthält, eine wesentlich verbesserte Verschleißfestigkeit und Oxidationsbeständigkeit zu erreichen.

Diese Aufgabe wird mit den Merkmalen der Patentansprüche gelöst.

Die erfindungsgemäßen hartstoffbeschichteten Körper sind dadurch gekennzeichnet, dass sie mit mindestens einer mittels CVD ohne Plasmaanregung erzeugten Ti₁₋ₓAlₓN-Hartstoffschicht beschichtet sind, die als einphasige Schicht in der kubischen NaCl-Struktur mit einem Stöchiometriekoeffizienten x > 0,75 bis x = 0,93 und einer Gitterkonstante a_{fcc} zwischen 0,412 nm und 0,405 nm vorliegt. Weitere Merkmale dieser Ti₁₋ₓAlₓN-Hartstoffschicht bestehen darin, dass deren Chlorgehalt im Bereich zwischen nur 0,05 und 0,9 At.% liegt und der Härtewert der Ti₁₋ₓAlₓN-Hartstoffschicht(en) im Bereich von 2500 HV bis 3800 HV liegt.

Vorteilhafterweise liegt der Chlorgehalt der Ti₁₋ₓAlₓN-Hartstoffschicht(en) im Bereich von nur 0,1 bis 0,5 At.% und der Sauerstoffgehalt im Bereich von 0,1 bis 5 At. %.

Die auf den Körpern erfindungsgemäß vorhandene Schicht weist mit ihrer hohen Härte zwischen 2500 HV bis 3800 HV und mit einer gegenüber dem Stand der Technik deutlich verbesserten Oxidationsbeständigkeit, die durch den hohen AIN-Anteil in der kubischen Ti₁₋ₓAlₓN-Phase erreicht wird, eine bisher nicht erreichte Kombination von Härte und Oxidationsbeständigkeit auf, die insbesondere bei hohen Temperaturen eine sehr gute Verschleißbeständigkeit ergibt.

Zur Herstellung der Körper beinhaltet die Erfindung ein Verfahren, das dadurch gekennzeichnet ist, dass die Körper in einem Reaktor bei Temperaturen im Bereich von 700°C bis 900°C mittels CVD ohne Plasmaanregung beschichtet werden, wobei als Precursoren Titanhalogenide, Aluminiumhalogenide und reaktive Stickstoffverbindungen Verwendung finden, die bei erhöhter Temperatur gemischt werden.

Als reaktive Stickstoffverbindungen können erfindungsgemäß NH₃ und/oder N₂H₄ eingesetzt werden.

Die Precursoren werden in vorteilhafter Weise im Reaktor unmittelbar vor der Abscheidungszone gemischt.

Die Mischung der Precursoren wird erfindungsgemäß bei Temperaturen im Bereich von 150°C bis 900°C durchgeführt.

Die Beschichtung wird vorteilhaft bei Drücken im Bereich von 10² Pa bis 10⁵ Pa durchgeführt.

Mit dem erfindungsgemäßen Verfahren ist es möglich, durch einen vergleichsweise einfachen thermischen CVD-Prozess bei Temperaturen zwischen 700°C und 900°C und Drücken zwischen 10² Pa und 10⁵ Pa Ti₁₋ₓAlₓN-Schichten mit der NaCl-Struktur herzustellen. Mit dem Verfahren sind sowohl die bisher bekannten Ti₁₋ₓAlₓN-Schichtzusammensetzungen mit x < 0,75 als auch die neuartigen Zusammensetzungen mit x > 0,75 erhältlich, die mit keinem anderen Verfahren herstellbar sind. Das Verfahren erlaubt die homogene Beschichtung auch komplizierter Bauteilgeometrien.

### Ausführungsformen der Erfindung

Nachfolgend ist die Erfindung an Ausführungsbeispielen näher erläutert.

### Beispiel 1

Auf WC/Co-Hartmetallwendeschneidplatten wird eine Ti₁₋ₓAlₓN-Schicht mittels des erfindungsgemäßen thermischen CVD-Verfahrens abgeschieden. Dazu wird in einem Heißwand-CVD-Reaktor mit einem Innendurchmesser von 75 mm eine Gasmischung aus 20 ml/min AlCl₃, 3,5 ml/min TiCl₄, 1400 ml/min H₂, 400 ml/min Argon bei einer Temperatur von 800°C und einem Druck von 1 kPa eingeleitet.

Über eine zweite Gaszuführung wird ein Gemisch aus 100 ml/min NH₃ und 200 ml/min N₂ in den Reaktor geführt. Die Vermischung beider Gasströme erfolgt in einem Abstand von 10 cm vor dem Substratträger. Nach einer Beschichtungszeit von 30 Minuten wird eine grauschwarze Schicht mit einer Dicke von 6 µm erhalten.

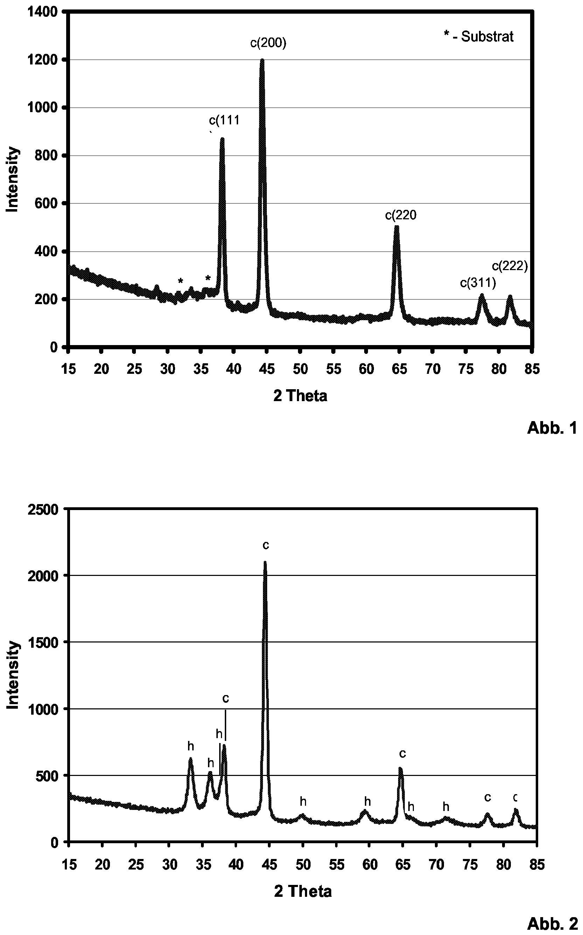

Mittels der im streifenden Einfall durchgeführten röntgenographischen Dünnschichtanalyse wird nur die kubische Ti₁₋ₓAlₓN-Phase gefunden (siehe Röntgendiffraktogramm Abb. 1).

Die ermittelte Gitterkonstante beträgt a_{fcc} = 0,4085 nm. Das mittels WDX bestimmte Atomverhältnis Ti:Al beträgt 0,107. Die ebenfalls bestimmten Gehalte an Chlor und Sauerstoff betragen 0,1 At.% für Cl und 2,0 At.% für O.

Die Berechnung des Stöchiometriekoeffizienten ergibt x = 0,90. Mittels Vickersindenter wird eine Härte der Schicht von 3070 HV[0,05] gemessenen. Die Ti₁₋ₓAlₓN-Schicht ist an Luft oxidationsbeständig bis 1000°C.

### Beispiel 2 (Vergleichsbeispiel)

Auf Wendeschneidplatten aus Si₃N₄-Schneidkeramik wird zunächst eine 1 µm dicke Titannitridsch icht mittels eines bekannten Standard-CVD-Prozesses bei 950°C aufgebracht. Danach wird mit dem erfindungsgemäßen CVD-Verfahren unter Verwendung der im Beispiel 1 beschriebenen Gasmischung, einem Druck von 1 kPa und einer Temperatur von 850°C eine grauschwarze Schicht abgeschieden.

Die röntgenographische Dünnschichtanalyse ergibt, dass hier ein heterogenes Gemisch von Ti₁₋ₓAlₓN mit der NaCl-Struktur und AlN mit der Wurtzitstruktur vorliegt. Im ermittelten Röntgendiffraktogramm von Abb. 2 sind die Reflexe des kubischen Ti₁₋ₓAlₓN mit c und die des hexagonalen AlN (Wurtzitstruktur) mit h gekennzeichnet. Der Anteil des kubischen Ti₁₋ₓAlₓN in der Schicht überwiegt.

Die ermittelte Gitterkonstante der kubischen Phase beträgt a_{fcc} = 0,4075 nm. Die zweite, hexagonale AlN-Phase hat Gitterkonstanten von a = 0,3107 nm und c = 0,4956 nm. Die mittels Vickersindenter bestimmte Härte der Schicht beträgt 3150 HV[0,01]. Die zweiphasige Ti₁₋ₓAlₓN-Schicht ist an Luft oxidationsbeständig bis 1050°C.

## Patentansprüche

1. Hartstoffbeschichtete Körper mit einem ein- oder mehrlagigen Schichtsystem, das mindestens eine mittels CVD ohne Plasmaanregung erzeugte Ti₁₋ₓAlₓN-Hartstoffschicht enthält, wobei die Ti₁₋ₓAlₓN-Hartstoffschicht als einphasige Schicht in der kubischen NaCl-Struktur mit einem Stöchiometriekoeffizienten x > 0,75 bis x = 0,93 und einer Gitterkonstante a_{fcc} zwischen 0,412 nm und 0,405 nm vorliegt,
und wobei der Chlorgehalt der Ti₁₋ₓAlₓN-Hartstoffschicht im Bereich von 0,05 bis 0,9 At.% liegt und wobei der Härtewert der Ti₁₋ₓAlₓN-Hartstoffschicht(en) im Bereich von 2500 HV bis 3800 HV liegt.

2. Hartstoffbeschichtete Körper nach Anspruch 1, **dadurch gekennzeichnet, dass** der Chlorgehalt der Ti₁₋ₓAlₓN-Hartstoffschicht(en) im Bereich von 0,1 bis 0,5 At.% liegt.

3. Hartstoffbeschichtete Körper nach Anspruch 1, **dadurch gekennzeichnet, dass** der Sauerstoffgehalt der Ti₁₋ₓAlₓN-Hartstoffschicht(en) im Bereich von 0,1 bis 5 At.% liegt.

4. Verfahren zur Herstellung hartstoffbeschichteter Körper mit einem ein- oder mehrlagigen Schichtsystem, das mindestens eine Ti₁₋ₓAlₓN-Hartstoffschicht enthält, nach wenigstens einem der Ansprüche 1-3, **dadurch gekennzeichnet, dass** die Körper in einem Reaktor bei Temperaturen im Bereich von 700 °C bis 900 °C mittels CVD ohne Plasmaanregung beschichtet werden, wobei als Precursoren Titanhalogenide, Aluminiumhalogenide und reaktive Stickstoffverbindungen Verwendung finden, die im Reaktor unmittelbar vor der Abscheidungszone bei erhöhter Temperatur gemischt werden.

5. Verfahren nach Anspruch 4, **dadurch gekennzeichnet, dass** als reaktive Stickstoffverbindungen NH₃ und/oder N₂H₄ eingesetzt werden.

6. Verfahren nach Anspruch 4, **dadurch gekennzeichnet, dass** die Mischung der Precursoren bei Temperaturen im Bereich von 150 °C und 900°C durchgeführt wird.

7. Verfahren nach Anspruch 4, **dadurch gekennzeichnet, dass** die Beschichtung bei Drücken im Bereich von 10² Pa bis 10⁵ Pa durchgeführt wird.

## Claims

1. Hard material-coated bodies having a single-layer or multilayer layer system which contains at least one Ti₁₋ₓAlₓN hard material layer produced by means of CVD without plasma excitation, where the Ti₁₋ₓAlₓN hard material layer is present as a single-phase layer having the cubic NaCl structure having a stoichiometric coefficient from x > 0.75 to x = 0.93 and a lattice constant a_{fcc} in the range from 0.412 nm to 0.405 nm,
and where the chlorine content of the Ti₁₋ₓAlₓN hard material layer is in the range from 0.05 to 0.9 at% and where the hardness value of the Ti₁₋ₓAlₓN hard material layer(s) is in the range from 2500 HV to 3800 HV.

2. Hard material-coated bodies according to Claim 1, **characterized in that** the chlorine content of the Ti₁₋ₓAlₓN hard material layer(s) is in the range from 0.1 to 0.5 at%.

3. Hard material-coated bodies according to Claim 1, **characterized in that** the oxygen content of the Ti₁₋ₓAlₓN hard material layer(s) is in the range from 0.1 to 5 at%.

4. Process for producing hard material-coated bodies having a single-layer or multilayer layer system which contains at least one Ti₁₋ₓAlₓN hard material layer according to at least one of Claims 1-3, **characterized in that** the bodies are coated by means of CVD without plasma excitation in a reactor at temperatures in the range from 700°C to 900°C, where titanium halides, aluminium halides and reactive nitrogen compounds are used as precursors and are mixed at elevated temperature in the reactor immediately before the deposition zone.

5. Process according to Claim 4, **characterized in that** NH₃ and/or N₂H₄ are used as reactive nitrogen compounds.

6. Process according to Claim 4, **characterized in that** the mixing of the precursors is carried out at temperatures in the range from 150°C to 900°C.

7. Process according to Claim 4, **characterized in that** coating is carried out at pressures in the range from 10² Pa to 10⁵ Pa.

## Revendications

1. Corps revêtus par une substance dure, présentant un système à couches monocouche ou multicouche, qui contient au moins une couche de substance dure en Ti₁₋ₓAlₓN générée par CVD sans excitation au plasma, la couche de substance dure en Ti₁₋ₓAlₓN se trouvant sous forme d'une couche à une phase dans la structure de NaCl cubique dotée d'un coefficient stoechiométrique x > 0,75 à x = 0,93 et d'une constante de réseau a_{fcc} entre 0,412 nm et 0,405 nm,
et la teneur en chlore de la couche de substance dure en Ti₁₋ₓAlₓN se situant dans la plage de 0,05 à 0,9 % en atomes et la valeur de dureté de la/des couche(s) de substance dure en Ti₁₋ₓAlₓN se situant dans la plage de 2 500 HV à 3 800 HV.

2. Corps revêtus par une substance dure selon la revendication 1, **caractérisés en ce que** la teneur en chlore de la/des couche(s) de substance dure en Ti₁₋ₓAlₓN se situe dans la plage de 0,1 à 0,5 % en atomes.

3. Corps revêtus par une substance dure selon la revendication 1, **caractérisés en ce que** la teneur en oxygène de la/des couche(s) de substance dure en Ti₁₋ₓAlₓN se situe dans la plage de 0,1 à 5 % en atomes.

4. Procédé pour la fabrication de corps revêtus par une substance dure présentant un système à couches monocouche ou multicouche, qui contient au moins une couche de substance dure en Ti₁₋ₓAlₓN, selon au moins l'une quelconque des revendications 1-3, **caractérisé en ce que** les corps sont revêtus dans un réacteur à des températures dans la plage de 700 °C à 900 °C par CVD sans excitation au plasma, des halogénures de titane, des halogénures d'aluminium et des composés réactifs de l'azote étant utilisés comme précurseurs, qui sont mélangés dans le réacteur directement en amont de la zone de dépôt à température élevée.

5. Procédé selon la revendication 4, **caractérisé en ce qu'**on utilise, comme composés réactifs de l'azote, NH₃ et/ou N₂H₄.

6. Procédé selon la revendication 4, **caractérisé en ce que** le mélange des précurseurs est réalisé à des températures dans la plage de 150 °C à 900 °C.

7. Procédé selon la revendication 4, **caractérisé en ce que** le revêtement est réalisé à des pressions dans la plage de 10² à 10⁵ Pa.
